# EUROPEAN PATENT APPLICATION

(11) **EP 3 709 337 A2**
(43) Date of publication of application: **16.09.2020**
(21) Application number: 20460005.0
(22) Date of filing: 29.01.2020
(51) Int. Cl.: H01J 37/32, A23B 7/015, H05H 1/24

(54) **NON-THERMAL PLASMA REACTOR OF BARRIER DISCHARGE FOR DISINFECTION AND/OR STERILIZATION OF ORGANIC PRODUCTS**

(30) Priority: 19.02.2019 PL 42896919
(71) Applicant: University of Science and Technology, 85-796 Bydgoszcz (PL)
(72) Inventor: Mucko, Jan, 86-021 Maksymilianowo (PL); Panka, Dariusz, 86-061 Olimpin (PL); Domanowski, Piotr, 86-050 Solec Kujawski (PL); Bujnowski, Slawomir, 86-010 Koronowo (PL)

(57) **Abstract**

The described invention is a non-thermal plasma reactor of barrier discharge for disinfection and/or sterilization of organic products. The reactor may be especially applied for laboratory tests of disinfection or sterilization efficiency with the use of non-thermal plasma in order to determine parameters of industrial, technological processing of organic material. The reactor of non-thermal plasma of barrier discharge for disinfection and/or sterilization of organic products is characterized by the fact that it consists of a base 1 on which a discharging chamber in the form of closed 2 or open casing 3 is located that is destined to work with fixed or variable pressure and in the upper part of the chamber there is a dielectric hold 11, which may be adjusted vertically in which an isolating support 10 with electrode 5 of AC high voltage (HV) is located that consists of at least one pipe (tube) 6, made of glass and filled with substance 7 conducting electricity and below which a lower grounded electrode 12 is situated in the form of a transporter cart with back and forth movement mechanism 13, where the distance between the upper electrode 5 and the lower electrode amounts to 1-15 mm.

## Description

The described invention is a non-thermal plasma reactor of barrier discharge for disinfection and/or sterilization of organic products. The reactor may be applied especially for laboratory tests of disinfection or sterilization efficiency with the use of non-thermal plasma in order to determine parameters of industrial and technological processing of organic material.

Ways of using plasma technology in the food industry and agriculture have been described many times in the specialist literature, which is testified by many publications such as, for example: N Misra et al, Cold Plasma in Food and Agriculture: Fundamentals and Applications, Elsevier 2016, L.C.O. Santos et al, Use of Cold Plasma To Inactivate Escherichia Coli and Physicochemical Evaluation in Pumpkin Puree, Journal of Food Protection, 2018, doi:10.4315/0362-028X.JFP-18-136, Shashi K. et al, Effects of Cold Plasma on Food Quality: A Review, Center for Crops Utilization Research, Iowa State University, 2018., Stryczewska H.: 2011. Technologie zimnej plazmy. Wytwarzanie, modelowanie, zastosowania. Elektryka [Cold Plasma Technologies. Producing, Modelling, Applications. Electric Issues], 217:41-61, L. Han et al, Mechanisms of Inactivation by High-Voltage Atmospheric Cold Plasma Differ for Escherichia coli and Staphylococcus aureus, Applied and Environmental Microbiology, 2016, doi: 10.1128/AEM.02660-15. However, all these above publications present only some general rules of generating plasma of barrier discharge, omitting the issue of such reactor's detailed construction.

We also know constructions of non-thermal plasma reactors for sterilization of organic products or sterilization of medical equipment.

From the patent no PL.230798 we know a movable, multi-needle upper electrode with high electric potential that may move only in the vertical direction, whereas the disinfected or sterilized material remains still. Its discharge power is limited to c. 350W. It is advisable that there should be a dielectric under the upper electrode, and at least one Peltier's element should be placed on the casing.

From the patent no PL.225217 we know the way of processing with the use of the equipment described in patent PL.230798, where processing time with low temperature plasma amounts to a few minutes.

From the patent no DE.102009025864 we know the way and equipment for sterilization of food and flavouring with the use of low temperature plasma. However, the description of this equipment misses some important information on its construction details such as, for example, the construction and shape of electrodes, construction of the discharge chamber (reactor), its voltage, frequency and power values.

The known equipment for sterilization of medical equipment makes use of non-thermal plasma where plasma operation time ranges from a few dozen minutes to a few hours with relatively low discharge power. The disinfected or sterilized material remains still. In the case of devices for sterilization of medical equipment, their producers do not reveal their discharge power but only the power consumed by the whole device.

Industrial processing of organic food products and seeds requires acceleration of the process of decreasing microflora, i.e. decreasing the time of plasma operation and increasing the discharge power. At the same time, emitted doze of energy should not destroy the material under processing. In order to achieve this, new constructions of non-thermal plasma reactors of barrier discharge for disinfection and/or sterilization of organic products have been developed.

The idea of the solution behind this invention is the construction of non-thermal plasma reactor of barrier discharge for disinfection and/or sterilization of organic products that consists of a discharge chamber, where electrodes - upper and down ones - are located opposite each other and between them the processed material is placed. The upper electrode is an alternating current (AC) high voltage electrode that is located in a dielectric hold with a position adjustment, whereas below it there is a down electrode which is grounded with a sliding mechanism on which the material is placed, with the distance between the upper and the material being adjustable and amounting to 1 - 15 mm.

The reactor according to this invention consists of a base 1, on which discharge chamber made up of airtight casing 2 is placed that is meant for working in gas environment with variable pressure or optionally of casing 3, which is non-tight and meant to work in normal (atmospheric pressure) and equipped with ventilation duct 4, and in the upper part of the chamber 3 there is a dielectric hold 11, whose position may be adjusted vertically, in which an isolation support element is placed 10 with the upper electrode 5 of AC high voltage HV and which consists of at least one pipe (tube) 6 made of glass or ceramic material filled with substance 7 conducting electricity. Below the upper electrode 5 there is a lower, grounded electrode 12, on which material 18 that is processed with the lower electrode is placed, in the form of a transport cart 12 with back and forth motion mechanism 13, along the chamber 3, on horizontal surface or in the form of a metal plate 14; under the lower electrode there a dielectric or electricty conducting belt conveyor 15 is located, or it is in the form of electricty conducting vibration transport 16, with the distance between the upper electrode 5 and the lower electrode amounting to 1 - 15 mm.

In another version, the reactor consists of a discharge chamber in the form of casing 3, where on isolating supports 17 (that make it possible to change distance between the electrodes), at least two electrodes 8 are situated in the form of metal, rotating cylinders - pipes covered with dielectric 9 made of glass, ceramic or silicone and rotating in opposite directions to each other, with vectors of linear speed of electrode surfaces in the discharge places being in accordance with the direction of processed material. One of the electrodes is connected to AC high voltage (HV) and the other one is grounded (GND); optionally, one electrode may be connected to high voltage (HV) and the other one to high voltage (HV) of opposite phase. In the place of chute of the processed material 18, from a conveyor 15 and under electrodes 9, there are brushes 19 made of isolating material that are destined to remove the processed material 18 which may stick to the conveyor's belt 15 and electrode's surfaces 9.

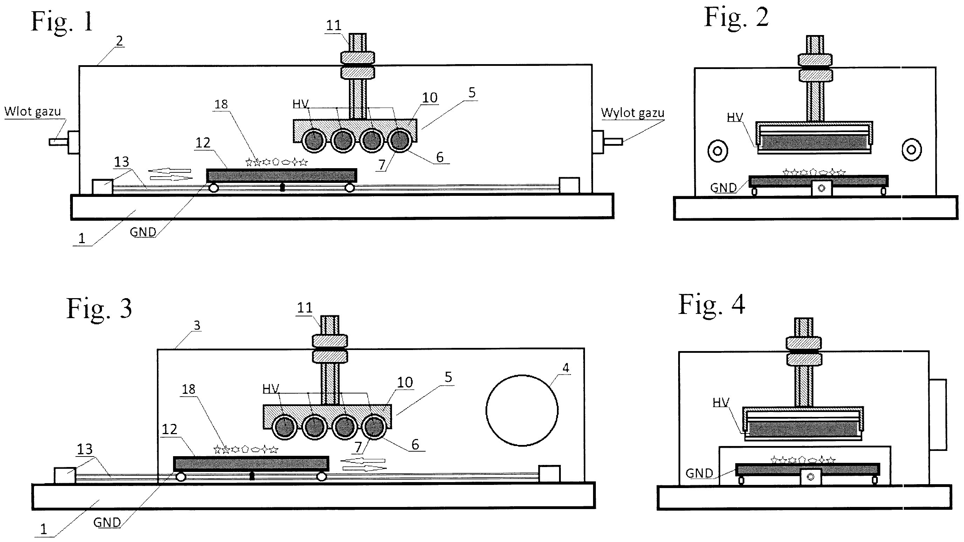

The way of disinfecting and/or sterilization of organic products according to the invention consists in the fact that the processed material is moved by a cart under at least one stationary (still) or rotating HV electrode, once or many times, with a back and forth movement with scheduled number of cycles, fig.1-4.

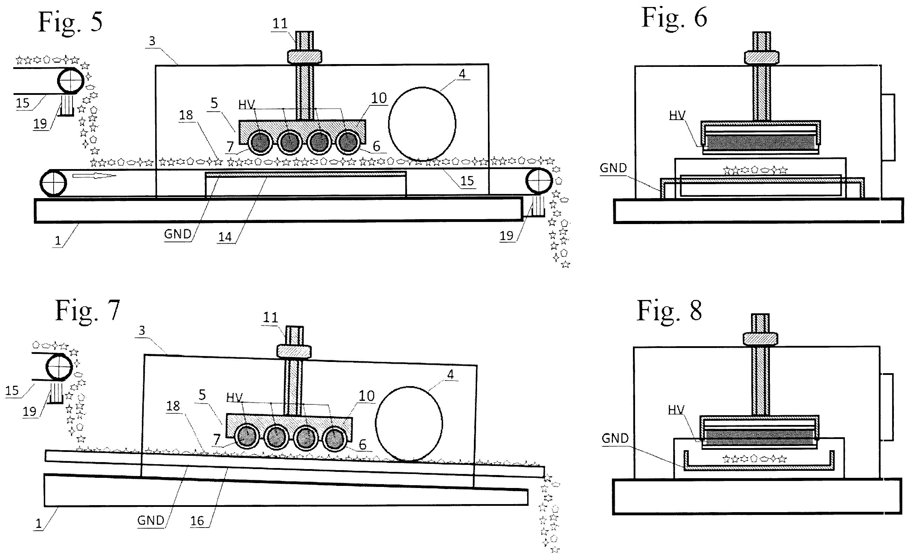

In another variant, the material is transported with the use of belt conveyor or vibration transport, fig.5-7.

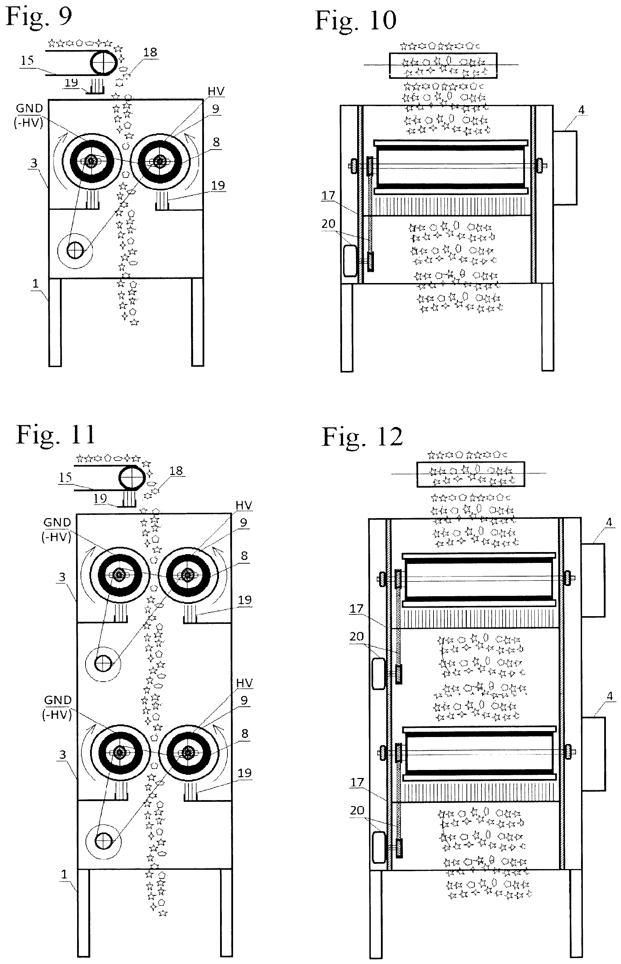

In another variant, the material is loaded from upside by gravitalion between at least two stationary or rotating electrodes, fig.9-12.

This way provides uniformity of processing in a wide range of power and energy control, increasing precision of dosing energy. Controlling the itensity of plasma processing of organic material takes place by controlling power with the use of modulating: density (PDM) or frequency (PFM) or amplitude (PAM) or filling (PWM) of high voltage electric impulses or simultaneous use of the above methods, adjusting at the same time the distance between the electrodes, speed of moving of the processed material and the number of processing cycles. The use of rotating electrodes improves cooling as electrode increase their temperature in the place of discharge, whereas cooling down takes place over the whole surface of an electrode.

Ozone produced in the discharge chamber is used for other processing procedures, such as for example, initial sterilization/disinfection during drying up of the material being processed.

Ozone from the discharge chamber is transported with the use of the duct 4 to other devices, e.g. drying up chamber preparing initial processing.

The reactors' power ranges between 0 - 20W for every centimeter of summed up length of HV electrodes (e.g. up to c. 1000W with summed up length of HV electrodes of 50 cm), voltage between the electrodes from a few to about 30kV and voltage frequency from a few to about 100kHz. Material processing in the reactor (Fig. 3, Fig. 4) consists in placing a sample of processed material 18 on the transporter cart's surface 12 and adjusting height of the discharging electrodes 7 with the use of the hold's knob 11 within 1 - 15 mm. Then, with the use of elements controlling movement of the cart and generator's power, speed of the cart, number of cycles, generator's power are set followed by starting the cart and the generator. The control system records parameters of the process and calculates energy provided to the tested sample. When the process is over, the processed material is microbiologically examined. The results of such microbiological examinations are compared with the results of unprocessed material. Tests are repeated for various settings of the processing parameters in order to find optimum parameters due to assumed criteria of limiting pathogens.

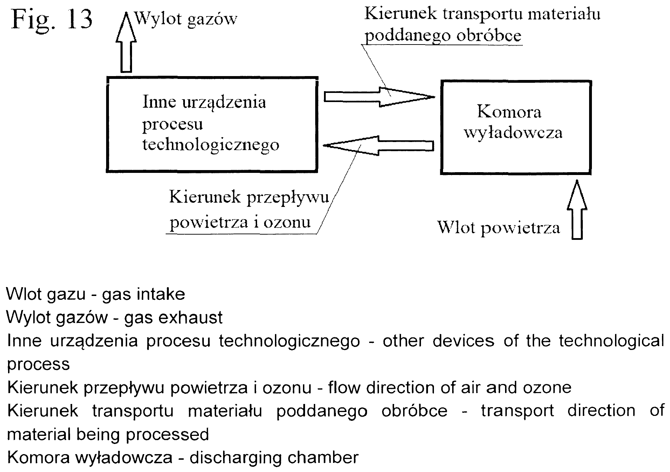

The invention was presented in examples of completed objects in the attached figures, where Fig.1-12 present examples of implementation of reactors of non-thermal plasma of barrier discharge for disinfection and/or sterilization of organic products, whereas Fig.13 presents supporting of the process of disinfection and/or sterilization with the use of ozone produdced in the discharging chamber.
Fig.1. Plasma reactor with airtight casing - front view
Fig.2. Plasma reactor with airtight casing - side view
Fig.3. Plasma reactor with non-airtight casing in variant 2 - front view
Fig.4. Plasma reactor with non- airtight casing in variant 2 - side view
Fig.5. Plasma reactor in variant 3 with metal plate under the transporter - front view
Fig.6. Plasma reactor in variant 3 - side view
Fig.7. Plasma reactor in variant 4 with vibration transporter - front view
Fig.8. Plasma reactor in variant 4 - side view
Fig.9. Plasma reactor in variant 5 with upper transporter - front view
Fig.10. Plasma reactor in variant 5 - side view
Fig.11. Plasma reactor in variant 6 with upper transporter - front view
Fig.12. Plasma reactor in variant 6 - side view
Fig.13.Scheme of supporting the process of disinfection and/or sterilization with the use of ozone produced in the discharging chamber.

The reactor was presented in more detailed way in the following working examples.

### Example 1

The reactor consists of a base 1, on which a discharging chamber in casing is located 2 that is airtight, closed, destined for work under variable pressure, in gas environment, with dielectric hold 11 located in the upper part of the chamber 3 that is adjusted vertically with an isolating support 10 with an AC high voltage electrode 5, below which a metal, grounded electrode 12 is situated with processed material 18; the lower electrode has the form of a transporter cart with back and forth mechanism 13 and the distance between the upper electrode 5, the material 18 and the lower electrode amounts to 1 mm.

### Example 2

Discharging chamber in non-airtight casing 3 destined for work under atmospheric pressure equipped with ventilation duct 4, with dielectric hold 11 located in the upper part of the chamber 3 that is adjusted vertically with an isolating support 10 with an AC high voltage electrode 5 in the form of three pipes (tubes) made of glass and filled with electricty conducting substance 7, below which a metal, grounded electrode 12 is situated with processed material 18; the lower electrode has the form of a transporter cart with back and forth mechanism 13 and the distance between the upper electrode 5, the material 18 and the lower electrode amounts to 3 mm.

### Example 3

Discharging chamber in non-airtight casing 3 with dielectric hold 11 that is adjusted vertically with an isolating support 10 with an AC high voltage electrode 5 in the form of two pipes (tubes) made of ceramic material and filled with electricty conducting substance 7, below which a metal, grounded electrode 12 is situated with processed material 18; the lower electrode has the form of a metal plate 14, located under the dielectric or electricity conducting belt conveyor 15, with the distance between the upper electrode 5 and the material 18 and the lower electrode amounts to 6 mm.

### Example 4

The reactor consists of a base 1, on which a discharging chamber 3 in casing is located 2 that is non-airtight, with dielectric hold 11 located in the upper part of the chamber that is adjusted vertically with an isolating support 10 with an AC high voltage electrode 5, in the form of two pipes (tubes) made of ceramic material filled with substance 7 conducting electricty, below which a metal, grounded electrode 12 is situated with processed material 18; the lower electrode has the form of a vibration transporter 16 and the distance between the upper electrode 5, the material 18 and the lower electrode amounts to 5 mm.

### Example 5

The reactor consists of a base 1, on which a discharging chamber 3 in casing is located 2 that is non-airtight, with ventilation duct 4 and a dielectric hold 11 located in the upper part of the chamber that is adjusted vertically with an isolating support 10 with electrode 5, in the form of one pipe (tube) made of glass filled with substance conducting AC high voltage electricity, below which a metal, grounded electrode 12 is situated with processed material 18; the lower electrode has the form of a belt conveyor 15 and the distance between the upper electrode 5, the material 18 and the lower electrode amounts to 10 mm.

### Example 6

The reactor consists of a base 1, on which a discharging chamber 3 in casing is located 2 that is non-airtight, with a ventilation duct 4 and a dielectric hold 11 located in the upper part of the chamber that is adjusted vertically with an isolating support 10 with an AC high voltage electrode 5, in the form of four pipes (tubes) made of ceramic material filled with substance conducting electricty, below which a metal, grounded electrode 12 is situated with processed material 18; the lower electrode has the form of a vibration transporter 16 and the distance between the upper electrode 5, the material 18 and the lower electrode amounts to 16 mm.

### Example 7

The reactor consists of a discharging chamber 3 in the form of casing 3 where two electrodes are located in the form of metal, rotating, cylinder pipes (tubes) 8 covered with dielectric mounted on isolating supports 17 that are driven mechanically and rotating in opposite to each other directions, with one electrode connected to high voltage (HV) and the other one to high voltage of opposite phase (-HV), and in the place of material chute 18 from the conveyor 15 and under electrodes 9, there are brushes 19, which are made of isolating material in order to remove the material 18 from the conveyor's belt 15 and electrodes 9.

### Example 8

The reactor consists of a discharging chamber 3 in the form of casing 3 where four electrodes are located in the form of two pairs of metal, rotating, cylinder pipes (tubes) 8, located one under the other, that are covered with dielectric 9 made of ceramic material and mounted on isolating supports 17 that are driven mechanically and rotating in opposite to each other directions, with one electrode connected to high voltage (HV) and the other one being grounded (GND), and in the place of material chute 18 from the conveyor 15 and under electrodes, brushes 19 are located.

## Claims

1. Reactor of non-thermal plasma of barrier discharge for disinfection and/or sterilization of organic products that is **characterized by** the fact that it consists of a base 1 on which a discharging chamber in the form of casing 2 is placed, airtight or non-airtight, with a dielectric hold located in the upper part of the chamber 11, adjusted horizontally, in which an isolating support 10 with an electrode 5 of AC high voltage (HV) are located that consists of at least one pipe (tube), 6 made of glass, filled with substance 7 conducting electricity and below which a lower electrode 12 is situated in the form of a transporter cart with back and forth movement mechanism 13, with the distance between the upper electrode 5 and the lower electrode amounting to 1-15 mm.

2. Reactor of non-thermal plasma of barrier discharge for disinfection and/or sterilization of organic products that is **characterized by** the fact that it consists of a discharging chamber in the form of casing 3, where on isolating supports 17, at least two electrodes 8 are located in the form of at least two metal, rotating cylinders, covered with a dielectric 9 made of ceramic material and rotating in opposite directions to each other, with vectors of linear speed of electrodes' surfaces in the place of discharge having the direction in accordance with the direction movement of the processed material, with one electrode connected to AC high voltage (HV), whereas the other one is grounded (GND) and at the end of the conveyor 15 and under their electrodes 9, there are brushes 19 made of isolating material.

3. The reactor according to the description in 1 is **characterized by** the fact that electrode 5 consists of four pipes (tubes) 6 made of ceramic material and filled with substance 7 conducting electricity.

4. The reactor according to the description in 1 is **characterized by** the fact that the discharging chamber is located in casing 3 that is non-airtight with a ventilation duct 4.

5. The reactor according to the description in 1 is **characterized by** the fact that the lower electrode 12 has the form of a metal plate 14, located under dielectric and/or electricity conducting belt conveyor 15.

6. The reactor according to the description in 1 is **characterized by** the fact that the lower electrode 12 has the form of a metal, electricity conducting vibration transporter 16.

7. The reactor according to the description in 1 is **characterized by** the fact that to one of the electrodes high voltage (HV) is connected and to the other one, high voltage of opposite phase (-HV).

8. The reactor according to the description in 1 is **characterized by** the fact that the isolating material of the support 10 is protruded beyond the electrodes' 5 electricty conducting parts with a value of ≥ 1 mm.
